(19) Europäisches Patentamt
European Patent Office
Office européen des brevets

(11) EP 4 083 846 A1

(12) **DEMANDE DE BREVET EUROPEEN**

(43) Date de publication:
**02.11.2022 Bulletin 2022/44**

(21) Numéro de dépôt: **22166819.7**

(22) Date de dépôt: **05.04.2022**

(51) Classification Internationale des Brevets (IPC):
***G06F 30/27*** *(2020.01)* ***G06F 30/28*** *(2020.01)*
***G06N 3/08*** *(2006.01)* ***G06F 17/13*** *(2006.01)*

(52) Classification Coopérative des Brevets (CPC):
**G06N 3/08; G06F 17/13; G06F 30/27;** G06N 3/0454

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **27.04.2021 FR 2104371**

(71) Demandeur: **Commissariat à l'énergie atomique et aux énergies alternatives**
**75015 Paris (FR)**

(72) Inventeurs:
- **MENDIL, Mouhcine**
  **38054 Grenoble Cedex 09 (FR)**
- **LEIRENS, Sylvain**
  **38054 Grenoble Cedex 09 (FR)**
- **ARMAND, Patrick**
  **91297 Arpajon Cedex (FR)**
- **DUCHENNE, Christophe**
  **91297 Arpajon Cedex (FR)**

(74) Mandataire: **Atout PI Laplace**
**Immeuble "Visium"**
**22, avenue Aristide Briand**
**94117 Arcueil Cedex (FR)**

(54) **METHODE D'APPRENTISSAGE POUR LA DETERMINATION D'UN NIVEAU D'UNE GRANDEUR PHYSIQUE A EVOLUTION SPATIO-TEMPORELLE EN PRESENCE D'OBSTACLES PHYSIQUES DANS UNE ZONE SPATIALE CHOISIE**

(57) Méthode, mise en œuvre par ordinateur, de détermination d'un niveau d'une grandeur physique à évolution spatio-temporelle en présence d'obstacles physiques dans une zone quelconque, comprenant :
- dans une phase d'apprentissage (100), détermination (110), au moyen d'un apprentissage automatique recevant en entrée un premier ensemble d'obstacles physiques (11) et un premier ensemble de données (12), d'un modèle (13) pour ladite grandeur physique dans la zone prédéfinie ;
- dans une phase d'exploitation (200), détermination (210) d'un deuxième niveau (24) de la grandeur physique dans une zone quelconque, à partir du modèle (13) pour ladite grandeur physique recevant en entrée un deuxième ensemble d'obstacles physiques (21), distinct du premier ensemble d'obstacles physiques (11), et un deuxième ensemble de données (22).

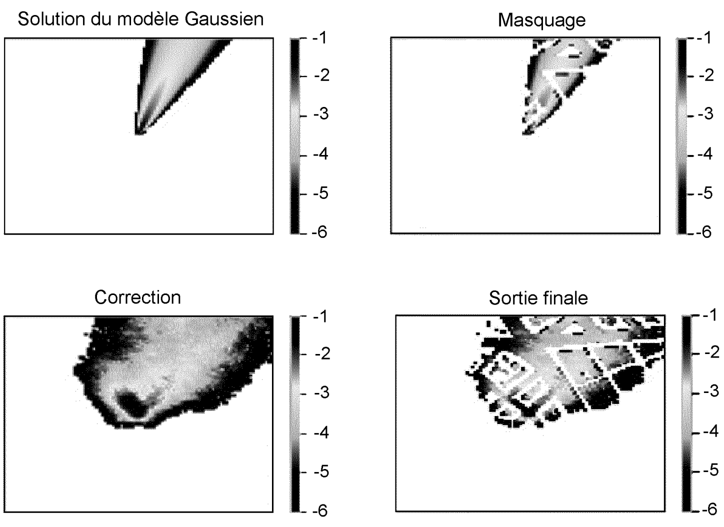


FIG.8

EP 4 083 846 A1

## Description

L'invention concerne le domaine de la modélisation des phénomènes physiques. Elle porte sur une méthode d'apprentissage pour la détermination d'un niveau d'une grandeur physique à évolution spatio-temporelle en présence d'obstacles physiques dans une zone spatiale choisie.

La compréhension de divers phénomènes du monde réel sont aujourd'hui en grande partie basées sur les Équations aux Dérivées Partielles (EDP). C'est en effet grâce à la modélisation de ces phénomènes au travers d'EDP que l'on peut comprendre et évaluer le rôle des paramètres en jeu, et obtenir des prévisions parfois extrêmement précises.

Les EDP se retrouvent dans de très nombreux domaines de la physique, notamment en acoustique, en mécanique des fluides, en électrodynamique et en mécanique quantique.

On s'intéresse ici aux EDP faisant intervenir des fonctions multivariées $u\colon \Omega \rightarrow \mathbb{R}^n$ et leurs dérivées partielles, définies dans un espace $\Omega \in \mathbb{R}^m$. La forme générale de l'EDP est la suivante :

$$F(x, u_x, u_{xx}, \dots) = 0, x \in \Omega \qquad (1)$$

où F est une fonction *a priori* non linéaire et $u_{\underbrace{x..x}_{\times k}}$ représente le vecteur de dérivées partielles d'ordre *k*.

Pour mieux illustrer la notation, considérons $x = (x_1, x_2, .., x_m) \in \Omega$ et $u = (u_1, u_2, \dots, u_n) \in \mathbb{R}^{n\Omega}$. On a :

$$\begin{cases} u_x = (u_{x_1}, u_{x_2}, \dots, u_{x_m}) \\ u_{xx} = (u_{x_1x_1}, u_{x_1x_2}, \dots, u_{x_1x_m}, u_{x_2x_1}, \dots, u_{x_mx_m}) \\ \dots \end{cases}$$

$$\begin{cases} u_{x_i} = \left(\frac{\partial u_1}{\partial x_i}, \frac{\partial u_2}{\partial x_i}, \dots, \frac{\partial u_n}{\partial x_i}\right),\ i \in \{1, 2, \dots, m\} \\ u_{x_ix_j} = \left(\frac{\partial^2 u_1}{\partial x_i \partial x_j}, \frac{\partial^2 u_2}{\partial x_i \partial x_j}, \dots, \frac{\partial^2 u_n}{\partial x_i \partial x_j}\right),\ (i, j) \in \{1, 2, \dots, m\}^2 \\ \dots \end{cases}$$

A l'équation (1), s'ajoutent un ensemble de contraintes de la physique (par exemple la conservation de masse et le bilan d'énergie) et des contraintes spatiales liées au milieu dans lequel le phénomène évolue. A noter que ces contraintes sont corrélées. On écrit de manière compacte ces contraintes comme ci-dessous :

$$C_{eq}(x, u_x, u_{xx}, \dots) = 0, x \in \Omega \qquad (2)$$

$$C_{ineq}(x, u_x, u_{xx}, \dots) \leq 0, x \in \Omega \qquad (3)$$

avec $C_{eq}$ et $C_{ineq}$ des fonctions a priori non-linéaires.

La solution de l'EDP consiste à trouver la fonction $u^*$ (supposée existante et unique) qui satisfait (1) et respecte les contraintes (2) et (3).

Dans leur formulation mathématique, les EDP représentent de manière conjointe les variations spatiales et temporelles du phénomène, c'est-à-dire la grandeur physique, étudié. Dans des cas simples et connus, on sait les résoudre analytiquement. Mais en général, il est rare que l'on puisse déterminer les solutions exactes. L'existence d'ordinateurs puissants permet néanmoins aujourd'hui d'obtenir, grâce à des méthodes numériques, des solutions approchées même pour des EDP très complexes.

En particulier, quelques EDP tiennent leur complexité de leur non-linéarité (par exemple l'équation de Navier-Stokes). Pour d'autres, la complexité vient des contraintes spatiales interférant avec le phénomène en question (milieu non-homogène, marqué par la présence d'obstacles physiques tels qu'un mur, un véhicule, un poteau, un bâtiment), qui rendent le problème difficile à formuler (nécessité de discrétiser) et à résoudre. Dans ces deux cas, l'implémentation de méthodes de résolution numérique nécessite des ressources importantes de calcul et de mémoire.

Face à cette limitation, des solutions tournées vers l'apprentissage automatique pour la résolution d'EDP sont récemment apparues.

En fonction de la complexité des approches utilisées, la phase d'apprentissage peut être longue et exigeante en données. Cela dit, l'apprentissage est effectué une seule fois et l'utilisation du modèle produit est efficace et économe en ressources.

Spécifiquement, il existe deux approches pour la résolution d'EDP grâce à des méthodes d'apprentissage.

La première approche s'intéresse à la résolution symbolique avec découverte de l'EDP. Elle repose sur une séquence de deux modèles d'apprentissage entraînés séparément.

D'abord, un réseau de neurones dense procède à la formulation de l'EDP incluant les contraintes spatiales, à partir d'un ensemble d'observations tel que décrit dans le document PCT/US2017/035781. Il s'agit de déterminer explicitement les coefficients de la fonction F (équation 1) à partir de la dynamique observée et de trouver l'écriture mathématique la plus simple possible (finie et exacte) combinant F, $C_{eq}$ et $C_{ineq}$ dans un même système d'équations.

Ensuite, à partir de la forme analytique de l'EDP trouvée à l'étape précédente, un Transformer (architecture de type LSTM) construit un arbre de calcul et résout symboliquement le système d'équations, comme cela est décrit dans la référence [4]. Il en résulte une expression exacte (continue) de la solution de l'EDP.

La seconde approche consiste à entraîner un modèle de régression avec des observations 2D ou 3D représentant l'évolution spatio-temporelle du phénomène. La méthode se base sur les réalisations historiques pour inférer des dynamiques non-linéaires sous-jacentes. Une fois que l'apprentissage converge, le modèle permet de faire des prévisions étant donné un état initial. Plusieurs architectures sont utilisées, comme décrit dans les références [2] et [3], la plupart s'appuyant sur des réseaux récurrents pour capturer la dépendance temporelle.

Les deux approches mentionnées ci-dessus peuvent modéliser avec une grande précision plusieurs familles d'EDP. Cependant, les modèles produits ne sont valables que pour les contraintes spatiales sur lesquelles ils ont été entraînés. Cela veut dire qu'un nouvel apprentissage doit être effectué à chaque changement dans l'environnement (ou pour un nouvel environnement) du phénomène étudié. On peut rapidement abandonner l'idée de construire une bibliothèque de modèles par combinaison de contraintes à cause de la quantité irréaliste de données et d'espace de stockage que cela nécessiterait.

Dans les solutions de l'art antérieur, la réutilisation des modèles dans d'autres environnements est bridée par l'absence d'une représentation efficace des contraintes spatiales durant l'apprentissage.

L'invention vise à pallier tout ou partie des problèmes cités plus haut en proposant une méthode d'apprentissage pour la résolution d'équations aux dérivées partielles de phénomènes physiques soumis à des contraintes spatiales. La méthode proposée permet, à l'issue de l'apprentissage, d'approximer la solution de l'EDP pour des conditions initiales et sous contraintes spatiales similaires ou différentes de celles rencontrées lors de la phase d'apprentissage. Les conditions initiales font partie des données d'entrée d'apprentissage pour la phase d'apprentissage.

L'invention a pour objet une méthode, mise en œuvre par ordinateur, de détermination d'un niveau d'une grandeur physique à évolution spatio-temporelle en présence d'obstacles physiques dans une zone spatiale choisie, l'évolution de ladite grandeur physique étant régie par un système d'équations aux dérivées partielles, la méthode comprenant les étapes suivantes :

- Dans une phase d'apprentissage, détermination, au moyen d'un apprentissage automatique recevant en entrée un premier ensemble d'obstacles physiques appartenant à une première zone spatiale d'apprentissage et un premier ensemble de conditions initiales, d'un modèle pour ladite grandeur physique, et, optionnellement, d'un premier niveau de la grandeur physique dans la zone spatiale d'apprentissage ;

- Dans une phase d'exploitation, détermination d'un deuxième niveau de la grandeur physique dans une seconde zone spatiale choisie à partir du modèle pour ladite grandeur physique recevant en entrée un deuxième ensemble d'obstacles physiques, distinct du premier ensemble d'obstacles physiques, et un deuxième ensemble de conditions initiales,

  i. Affichage du deuxième niveau de la grandeur physique déterminé dans la zone spatialechoisie au moyen d'une interface graphique,

  ii. détermination de mesures de protection applicables si le deuxième niveau de la grandeur physique atteint un seuil d'alerte préalablement défini.

Avantageusement, l'étape de détermination du modèle pour ladite grandeur physique comprend les étapes de :

- Détermination d'une solution simplifiée du système d'équations aux dérivées partielles en absence d'obstacles physiques ;
- Représentation du premier ensemble d'obstacles physiques dans la zone spatiale d'apprentissage sous forme d'une première matrice de contraintes spatiales ;
- Application à la solution simplifiée d'une fonction de masquage paramétrée par la première matrice de contraintes spatiales pour obtenir une première solution intermédiaire du système d'équations aux dérivées partielles en présence du premier ensemble d'obstacles physiques ;
- Application à la première solution intermédiaire d'une fonction de correction déterminée par un réseau de neurones, pour obtenir le modèle pour ladite grandeur physique et une première solution corrigée de la grandeur physique dans la zone spatiale d'apprentissage ;
- Application à la première solution corrigée de la fonction de masquage paramétrée par la première matrice de contraintes spatiales pour obtenir le premier niveau de la grandeur physique du système d'équations aux dérivées partielles dans la zone spatiale d'apprentissage en présence du premier ensemble d'obstacles physiques.

Avantageusement, l'étape de détermination du deuxième niveau de la grandeur physique dans une zone spatiale choisie comprend les étapes suivantes :

- Représentation du deuxième ensemble d'obstacles physiques dans la zone spatiale choisie sous forme d'une deuxième matrice de contraintes spatiales ;
- Application au modèle d'une fonction de masquage paramétrée par la deuxième matrice de contraintes spatiales pour obtenir une deuxième solution intermédiaire du système d'équations aux dérivées partielles en présence du deuxième ensemble d'obstacles physiques ;
- Application à la deuxième solution intermédiaire de la fonction de correction du modèle, pour obtenir une deuxième solution corrigée de la grandeur physique dans la zone spatiale choisie pour le deuxième ensemble d'obstacles physiques ;
- Application à la deuxième solution corrigée de la fonction de masquage paramétrée par la deuxième matrice de contraintes spatiales pour obtenir le deuxième niveau de la grandeur physique du système d'équations aux dérivées partielles dans la zone spatiale choisie en présence du deuxième ensemble d'obstacles physiques.

Avantageusement, la fonction de masquage est un groupe d'opérations de convolution avec fonction d'activation non-linéaires.

Avantageusement, la fonction de correction est déterminée lors d'une phase d'apprentissage comprenant une étape d'exécution de plusieurs itérations d'un algorithme d'apprentissage automatique, recevant en entrée la solution intermédiaire, l'algorithme d'apprentissage automatique étant configuré pour déterminer la fonction de correction.

Avantageusement, les itérations de l'algorithme d'apprentissage automatique sont arrêtées après l'exécution d'un nombre prédéterminé d'itérations, ou quand l'erreur entre le niveau de la grandeur physique dans la zone spatiale d'apprentissage et un niveau de référence de la grandeur physique dans la zone spatiale d'apprentissage est inférieure à un seuil de convergence prédéterminé.

Dans un mode de réalisation de la méthode selon l'invention, la grandeur physique est un polluant, préférentiellement chimique ou sonore.

Dans un mode de réalisation de la méthode selon l'invention, l'apprentissage automatique du modèle réalisé lors de la phase d'apprentissage est alimenté par des données d'apprentissage comprenant une cartographie ou morphologie de la zone spatiale d'apprentissage réelle, comprenant ledit premier ensemble d'obstacles physiques.

Dans un mode de réalisation de la méthode selon l'invention, l'apprentissage, les données d'apprentissage comprennent en outre différents ensembles de conditions initiales appliquées à la zone spatiale d'apprentissage comprenant au moins différents ensembles de positions des sources d'émission de ladite grandeur physique dans la zone spatiale d'apprentissage.

Dans un mode de réalisation de la méthode selon l'invention, les différents ensembles de conditions initiales comprennent différents modèles de conditions météorologiques impactant la zone spatiale d'apprentissage

L'invention concerne aussi un programme d'ordinateur comportant des instructions pour l'exécution de la méthode selon l'invention, lorsque le programme est exécuté par un processeur.

L'invention concerne aussi un support d'enregistrement lisible par un processeur sur lequel est enregistré un programme comportant des instructions pour l'exécution de la méthode selon l'invention, lorsque le programme est exécuté par un processeur.

D'autres caractéristiques et avantages de la présente invention apparaîtront mieux à la lecture de la description qui suit en relation aux dessins annexés suivants.

[Fig. 1] représente, à titre explicatif, un schéma général d'un réseau de neurones artificiels utilisable dans le cadre de l'invention ;

[Fig. 2] représente un schéma de principe général de la méthode de détermination d'un niveau d'une grandeur physique à évolution spatio-temporelle en présence d'obstacles physiques dans une zone choisie avec une phase d'apprentissage et une phase d'exploitation ;

[Fig. 3] représente un schéma de principe général du fonctionnement d'une procédure d'apprentissage pour la résolution d'EDP soumise à des contraintes spatiales selon un mode de réalisation de l'invention ;

[Fig. 4] représente schématiquement une illustration d'une matrice de contrainte selon un mode de réalisation de l'invention ;

[Fig. 5] représente un schéma de principe général de la fonction de masquage selon un mode de réalisation de l'invention ;

[Fig. 6] représente un organigramme détaillant les étapes de mise en œuvre d'une procédure d'apprentissage pour la résolution d'EPD de la mécanique des fluides selon un premier exemple de réalisation de l'invention ;

[Fig. 7] représente schématiquement une illustration d'obstacles physiques (hyper-centre de Grenoble) à prendre en compte dans une matrice de contrainte selon le premier exemple de réalisation de l'invention ;

[Fig. 8] illustre des cartes de concentrations (échelle logarithmique) du résultat final et des résultats intermédiaires du modèle d'apprentissage (en phase d'exploitation) sur la dispersion atmosphérique d'un polluant dans l'hyper-centre de Grenoble selon le premier exemple de réalisation de l'invention ;

[Fig. 9] représente la répartition du polluant simulée par un modèle CFD de référence et assimilée à la réalité du terrain ;

[Fig. 10] représente un organigramme détaillant les étapes de mise en œuvre d'une procédure d'apprentissage pour la résolution d'EPD de propagation d'onde acoustique selon un deuxième exemple de réalisation de l'invention ;

[Fig. 11] représente schématiquement une illustration d'obstacles physiques à prendre en compte dans une matrice de contrainte selon le deuxième exemple de réalisation de l'invention ;

[Fig. 12] représente un schéma de principe général de la fonction de correction pour la propagation acoustique modélisée par un réseau de convolutions multi-échelles selon un mode de réalisation de l'invention ;

[Fig. 13] illustre des cartes de niveaux de pression acoustique (en décibels) du résultat final et des résultats intermédiaires du modèle d'apprentissage (en phase d'exploitation) sur la propagation acoustique dans un milieu avec obstacles selon le deuxième exemple de réalisation de l'invention ;

[Fig. 14] représente les niveaux de pression acoustique, simulée par le modèle d'automate cellulaire décrit dans la référence [5] et assimilée à la réalité du terrain.

[Fig. 15] représente un schéma de principe d'une variante de la procédure d'apprentissage pour la résolution d'EDP soumise à des contraintes spatiales selon un autre mode de réalisation de l'invention.

La figure 1 représente un schéma général d'un réseau de neurones artificiels, par exemple un réseau de neurones convolutionnel. Un réseau de neurones est classiquement composé de plusieurs couches Ce, Cl, Cl+1,Cs de neurones interconnectés. Le réseau comporte au moins une couche d'entrée Ce et une couche de sortie Cs et au moins une couche intermédiaire Cl, Cl+1. Les neurones Ni,e de la couche d'entrée Ce reçoivent chacun en entrée une donnée d'entrée. Les données d'entrée peuvent être de natures différentes selon l'application visée. Dans le contexte de l'invention, les données d'entrée sont des matrices représentant une grandeur physique. Un réseau de neurones a pour fonction générale d'apprendre à résoudre un problème donné qui peut être notamment un problème de transformations mathématiques ou de classification mais pas uniquement. Un réseau de neurones est, par exemple, utilisé dans le domaine de la modélisation de la dynamique spatio-temporelle d'un phénomène ou dans le domaine de la classification d'images ou de la reconnaissance d'images ou plus généralement la reconnaissance de caractéristiques qui peuvent être variées (visuelles, sonores ou les deux à la fois). Chaque neurone d'une couche est connecté, par son entrée et/ou sa sortie, à tous les neurones de la couche précédente ou suivante. Plus généralement un neurone peut n'être connecté qu'à une partie des neurones d'une autre couche, notamment dans le cas d'un réseau convolutionnel. Les connexions entre deux neurones Ni,e, Ni,l de deux couches successives se font à travers des synapses artificielles S1,S2,S3 qui peuvent être réalisées, notamment, par des mémoires numériques ou par des dispositifs memristifs. Deux opérations se succèdent au sein d'un neurone : 1) Calcul de la combinaison linéaire des valeurs en entrée pondérées par les poids synaptiques associés, à laquelle est ajouté un terme de biais. 2) Transformation du résultat par une fonction non-linéaire dite d'activation (par exemple ReLU ou sigmoïde). Les coefficients des synapses ainsi que les biais peuvent être optimisés grâce à un mécanisme d'apprentissage du réseau de neurones. Le mécanisme d'apprentissage a pour objectif l'entraînement du réseau de neurones à résoudre un problème défini. Ce mécanisme comporte deux phases distinctes, une première phase de propagation d'activations de la couche d'entrée vers la couche de sortie et une seconde phase de rétro-propagation de gradient d'erreurs de la couche de sortie vers la couche d'entrée avec, pour chaque couche, une mise à jour des poids des synapses et des biais. Dans le cas de l'apprentissage supervisé, la fonction de coût utilisée durant l'apprentissage calcule l'erreur entre les valeurs estimées (durant la propagation avant) par le réseau de neurones et les résultats attendus (supposés connus). Il s'agit, de manière générale, de minimiser cette erreur (par rétro-propagation) en fonction du problème à résoudre.

La description de la figure 1 est faite à titre illustratif d'un réseau de neurones, que l'Homme du métier connaît. Sur la base de ses connaissances, l'Homme du métier connaît le fonctionnement d'un réseau de neurones et sait l'utiliser. L'invention propose de déterminer un modèle de résolution composé d'une séquence d'opérations (appelées de masquage et de correction), dont les paramètres sont déterminés par apprentissage. A la lecture de la description, l'Homme du métier saura comment implémenter les principes de l'invention.

L'invention se base sur une utilisation particulière de différents types de réseaux de neurones artificiels pour résoudre un problème de détermination d'un niveau d'une grandeur physique, régie par des EDP, à évolution spatio-temporelle en présence d'obstacles physiques dans une zone spatiale choisie, par exemple une zone urbaine. Les principes généraux introduits ci-dessus servent à introduire les notions de base utilisées pour mettre en œuvre l'invention.

La figure 2 représente un schéma de principe général de la méthode de détermination d'un niveau d'une grandeur physique à évolution spatio-temporelle en présence d'obstacles physiques dans une zone spatiale choisie avec une phase d'apprentissage et une phase d'exploitation. L'évolution de ladite grandeur physique est régie par un système d'équations aux dérivées partielles. La méthode, mise en œuvre par ordinateur, de détermination d'un niveau d'une grandeur physique à évolution spatio-temporelle en présence d'obstacles physiques dans une zone spatiale choisie, comprend une phase d'apprentissage 100 et une phase d'exploitation 200. Dans la phase d'apprentissage 100, la première étape est une étape 110 de détermination, au moyen d'un apprentissage automatique recevant en entrée un premier ensemble d'obstacles physiques 11 présents dans une zone spatiale d'apprentissage prédéfinie et un premier ensemble de conditions initiales 12, d'un modèle 13 pour ladite grandeur physique, et, optionnellement, d'un premier niveau 14 de la grandeur physique dans la zone spatiale d'apprentissage.

Les données d'apprentissage utilisées lors de la phase d'apprentissage 100 sont constituées d'une topographie ou cartographie ou morphologie, dans tous les cas tridimensionnelle, d'une zone spatiale réelle, par exemple une zone urbaine comprenant un ensemble de bâtiments. Cette zone constitue une zone d'apprentissage. Les données d'apprentissage comprennent également un ensemble de conditions initiales ou données d'apprentissage qui peuvent être différentes positions des sources d'émission de la grandeur physique dans la zone d'apprentissage et/ou différentes conditions météorologiques qui impactent la zone d'apprentissage. Ainsi, la variabilité des données d'apprentissage est réalisée en faisant varier les conditions initiales 12 pour une zone d'apprentissage prédéfinie comprenant un ensemble d'obstacles physiques 11.

Dans la phase d'exploitation 200, un deuxième niveau 24 de la grandeur physique dans une zone choisie par l'utilisateur est déterminé (étape 210), à partir du modèle 13 pour ladite grandeur physique recevant en entrée un deuxième ensemble d'obstacles physiques 21 présents dans la zone choisie, distinct du premier ensemble d'obstacles physiques 11, et un deuxième ensemble de conditions initiales 22. La zone choisie par l'utilisateur dans la phase d'exploitation est différente de la zone d'apprentissage prédéfinie pour la phase d'apprentissage et comporte ainsi un deuxième ensemble d'obstacles physiques 21 différents du premier ensemble d'obstacles physiques 11.La méthode selon l'invention permet de déterminer le modèle pour une grandeur physique spécifique obtenu avec une phase d'apprentissage avec des contraintes spatiales spécifiques. Et la méthode permet d'utiliser ce même modèle ultérieurement avec un autre ensemble de contraintes spatiales, inconnues jusqu'alors du modèle. Autrement dit, le modèle obtenu pour ladite grandeur physique est utilisable avec d'autres contraintes spatiales (c'est-à-dire d'autres obstacles physiques), différentes de celles utilisées durant la phase d'apprentissage. Comme cela apparaîtra dans la description et les exemples ci-dessous, grâce à la flexibilité et la capacité de généralisation de la méthode de l'invention, aucun réapprentissage supplémentaire n'est nécessaire.

Le modèle entrainé vise à modéliser l'évolution de la grandeur physique dans une zone spatiale choisie, par exemple une zone urbaine, comprenant un ensemble d'obstacles physiques et soumise à différentes conditions initiales ; il ne vise pas à modéliser les obstacles physiques en tant que tels. La zone spatiale choisie peut être quelconque puisque l'invention permet l'apprentissage d'un modèle qui est ensuite applicable à tout type de zones spatiales.

Le deuxième niveau 24 de la grandeur physique dans une zone spatiale choisie déterminé lors de la phase d'exploitation 200 peut être restitué à un utilisateur par l'intermédiaire d'une interface graphique permettant de visualiser le niveau de la grandeur physique dans la zone choisie représentée en trois dimensions. La visualisation de ce résultat permet à un utilisateur de déclencher des mesures correctrices en fonction du niveau de la grandeur physique, par exemple en comparant ce niveau à un seuil d'alerte prédéfini.

La figure 3 représente un schéma de principe général du fonctionnement d'une procédure d'apprentissage pour la résolution d'EDP soumise à des contraintes spatiales selon un mode de réalisation de l'invention. L'étape 110 de détermination du modèle 13 pour ladite grandeur physique comprend une étape 120 de détermination d'une solution simplifiée $\tilde{U}$ du système d'équations aux dérivées partielles en absence d'obstacles physiques. Cette étape est réalisée par méthodes analytiques ou numériques en ignorant complètement les contraintes spatiales.

Lors de cette étape, on résout l'équation (1) sujette à un sous-ensemble de contraintes de (2) et (3), n'incluant pas les contraintes spatiales. Quitte à simplifier l'équation (1), on peut toujours se ramener à une EDP facile à résoudre analytiquement ou numériquement. Cette solution (notée $\tilde{U}$ sous sa forme matricielle) sert d'initialisation au modèle d'apprentissage. L'initialisation de $\tilde{U}$ permet de réduire la complexité de l'algorithme d'apprentissage, de faciliter sa convergence, et d'obtenir une meilleure précision des prévisions.

L'étape 110 comprend une étape 130 de représentation du premier ensemble d'obstacles physiques 11 dans la zone spatiale d'apprentissage, par exemple une zone urbaine, sous forme d'une première matrice de contraintes spatiales Mc1. Les valeurs de la matrice de contraintes spatiales sont ajustables par un modèle neuronal. Cette étape vise à prendre en compte l'environnement physique du phénomène étudié.

L'étape 110 comprend une étape 140 d'application à la solution simplifiée $\tilde{U}$ d'une fonction de masquage 141 paramétrée par la première matrice de contraintes spatiales Mc1 pour obtenir une première solution intermédiaire $\tilde{U}_M$ du système d'équations aux dérivées partielles en présence du premier ensemble d'obstacles physiques 11. Cette étape 140 consiste à appliquer les contraintes spatiales à la solution simplifiée. Comme cela sera explicité à l'aide d'exemples, l'étape de masquage permet de faire appliquer les contraintes spatiales mais lève les contraintes physiques.

Ensuite, l'étape 110 comprend une étape 150 d'application à la première solution intermédiaire $\tilde{U}_M$ d'une fonction de correction 151 déterminée par un réseau de neurones, pour obtenir le modèle pour ladite grandeur physique et une première solution corrigée $\tilde{U}_C$ de la grandeur physique dans la zone d'apprentissage. L'application de la correction restitue les contraintes physiques et établit la dynamique spatio-temporelle du phénomène (niveau de la grandeur physique), mais en contrepartie lève quelques contraintes spatiales. L'étape 150 consiste en l'application au résultat post-masquage d'une séquence de transformations non-linéaires, dites de correction et apprises par un réseau neuronal.

Afin de rétablir les contraintes physiques, l'étape 110 comprend encore une étape 140 d'application à la première solution corrigée $\tilde{U}_C$ de la fonction de masquage 141 paramétrée par la première matrice de contraintes spatiales Mc1 pour obtenir le modèle 13 de la grandeur physique du système d'équations aux dérivées partielles dans la zone d'apprentissage. Le résultat est le modèle 13. Ces itérations permettent aussi de déterminer un premier niveau 14 de la grandeur physique en présence du premier ensemble d'obstacles physiques 11.

Comme cela est représenté sur la figure 3, il est possible de répéter plusieurs fois les étapes 150 et 140. Il est possible de déterminer un seuil de convergence. L'apprentissage consiste à mettre à jour les paramètres du réseau de neurones pour minimiser la fonction de coût (par exemple le MSE pour *Mean Squared Error*). Le seuil de convergence est atteint quand, par exemple, la valeur de MSE (*Mean Squared Error*) est au minimum. La dernière étape doit être l'étape 140 d'application à la première solution corrigée $\tilde{U}_C$ de la fonction de masquage 141 pour rétablir les contraintes spatiales. En alternant masquage et correction, le modèle évolue progressivement vers la solution finale 13. La combinaison masquage-correction permet d'introduire l'effet des contraintes spatiales sans leur y associer directement un poids dans le modèle d'apprentissage. Sans cela, le modèle serait très complexe (nombre important de paramètres d'apprentissage) et par conséquent plus enclin au sur-apprentissage (apprendre les données par cœur plutôt que d'inférer les dynamiques sous-jacentes). A l'issue de la phase d'apprentissage, le modèle 13 permet d'approximer la solution de l'EDP sous différentes contraintes spatiales.

Pour ce faire, lors de la phase d'exploitation, l'étape 200 de détermination du deuxième niveau 24 de la grandeur physique dans la zone prédéfinie comprend les étapes suivantes :

- Représentation (230) du deuxième ensemble d'obstacles physiques 21 dans une zone choisie par l'utilisateur différente de la zone d'apprentissage sous forme d'une deuxième matrice de contraintes spatiales Mc2. Cette étape permet de prendre en compte l'environnement physique dans lequel on souhaite évaluer le niveau de la grandeur physique d'intérêt. Il s'agit donc ici d'un ensemble d'obstacles différent du premier ensemble d'obstacles utilisé dans la phase d'apprentissage.

- Application (240) au modèle 13 (déterminé une seule fois lors de la phase d'apprentissage) d'une fonction de masquage 242 paramétrée par la deuxième matrice de contraintes spatiales Mc2 pour obtenir une deuxième solution intermédiaire $\tilde{U}_{M2}$ du système d'équations aux dérivées partielles en présence du deuxième ensemble d'obstacles physiques 21 ;

- Application (250) à la deuxième solution intermédiaire $\tilde{U}_{M2}$ de la fonction de correction 151 du modèle, pour obtenir une deuxième solution corrigée $\tilde{U}_{C2}$ de la grandeur physique dans la zone qui a été choisie pour le deuxième ensemble d'obstacles physiques 21 ;

- Application (240) à la deuxième solution corrigée $\tilde{U}_{C2}$ de la fonction de masquage 242 paramétrée par la deuxième matrice de contraintes spatiales Mc2 pour obtenir le deuxième niveau 24 de la grandeur physique du système d'équations aux dérivées partielles dans la zone qui a été choisie en présence du deuxième ensemble d'obstacles physiques 21.

La figure 4 représente schématiquement une illustration d'une matrice de contrainte selon un mode de réalisation de l'invention, intervenant à l'étape 130 ou 230 de représentation d'un ensemble d'obstacles physiques dans la zone choisie considérée sous forme d'une matrice de contraintes spatiales. On définit la matrice de contraintes spatiales, notée $M_{C1}$, comme étant une représentation 2D du milieu dont le centre correspond à la source du phénomène étudié (par exemple le phénomène étudié peut être une concentration d'un polluant dans l'air et la source est alors le lieu d'émission de ce polluant). L'absence de contraintes est représentée par la valeur 1. Pour chaque contrainte de nature (ou composition) différente, on associe une valeur comprise entre 0 et 1. Ce choix peut s'appuyer sur les connaissances *a priori* de l'expert ou être aléatoire (à condition d'associer la même valeur au même type de contrainte). Dans le premier cas, les valeurs de la matrice $M_{C1}$ dépendent du type d'interaction physique à l'interface des contraintes spatiales. Dans l'exemple de la figure 4, à titre illustratif et non-limitatif, la surface 1 est réfléchissante, elle se voit associer la valeur de 0. Les surfaces 2 et 3 sont toutes les deux absorbantes, la première l'étant plus que la deuxième. On leur attribue respectivement les valeurs 0,3 et 0,7.

La figure 5 représente un schéma de principe général de la fonction de masquage 141 selon un mode de réalisation de l'invention. La fonction de masquage est une transformation de la solution simplifiée $\tilde{U}$ (sans tenir compte des contraintes spatiales), paramétrée par la matrice de contraintes spatiales $M_C$. Il s'agit dans un premier temps de trouver un encodage pour les valeurs de $M_C$ permettant d'ajuster (si nécessaire) l'effet des différentes compositions des contraintes spatiales sur le phénomène modélisé (la concentration du polluant dans l'exemple mentionné ci-dessus). Ceci est réalisé par un groupe d'opérations de convolution avec fonction d'activation non-linéaires (de type ReLU ou *Rectified Linear Unit*), impliquant k filtres de $\mathbb{R}^{a\times a}$ . Ces derniers sont appliqués à la matrice de contraintes spatiales à laquelle on aura préalablement concaténé des zéros aux contours (*zero-padding*). Les cartes de caractéristiques produites sont fusionnées par un filtre convolutif de taille 1 × 1. Ce dernier sert à calculer une somme pondérée des cartes de caractéristiques avant d'appliquer un opérateur non-linéaire. On obtient donc une matrice de dimensions similaire à $M_C$, qu'on note $C_C$. En introduisant ce degré de liberté supplémentaire, on permet une adaptation du masquage au modèle de correction durant l'apprentissage (rétro-propagation). Ceci a un intérêt particulièrement si les effets de bords sont inconnus ou difficilement chiffrables. Par ailleurs, l'analyse post-apprentissage de la matrice $C_C$ peut permettre d'identifier quantitativement l'effet d'un obstacle de composition donnée sur le phénomène étudié.

On applique finalement les contraintes spatiales à la solution simplifiée $\tilde{U}$ par une multiplication élément-par-élément pour obtenir la matrice $\tilde{U}_M$ :

$$\tilde{U}_M = \tilde{U} \odot C_C$$

$\odot$ étant le produit matriciel de Hadamard.

A ce stade, on obtient la solution intermédiaire notée $\tilde{U}_M$.

La fonction de masquage 141 a l'avantage de faire respecter les contraintes spatiales. Il en résulte cependant des discontinuités et des artefacts incohérents avec la physique du phénomène étudié. La dynamique spatio-temporelle n'est d'ailleurs pas encore considérée.

Pour modéliser la dynamique spatio-temporelle et rétablir les contraintes de la physique, on applique une séquence de transformations non-linéaires sur $\tilde{U}_M$, dites fonction de correction 151, apprises par un réseau de neurones. A noter que puisque le réseau de neurones n'a pas connaissance de la géométrie du problème (ce n'est pas une entrée de la fonction), le résultat de la fonction de correction a tendance à lever le respect des contraintes spatiales.

La fonction de correction peut être approximée par différents types de réseaux de neurones, en particulier un réseau convolutif ou de type encodeur/décodeur. Le choix dépend plus généralement de l'EDP à résoudre, mais une bonne pratique est de tester la procédure d'apprentissage proposée avec ces deux types de réseaux de neurones.

Dans la suite, la méthode d'apprentissage pour la résolution d'équations aux dérivées partielles de phénomènes physiques soumis à des contraintes spatiales est décrite au moyen de deux exemples.

La figure 6 représente un organigramme détaillant les étapes de mise en œuvre d'une procédure d'apprentissage pour la résolution d'EPD de la mécanique des fluides selon un premier exemple de réalisation de l'invention. Dans cet exemple, le phénomène étudié est un rejet accidentel de polluant atmosphérique en milieu urbain et la grandeur physique dont on souhaite suivre l'évolution est la concentration de ce polluant dans le milieu urbain choisi.

Dans le cas d'un rejet atmosphérique accidentel d'un polluant en milieu urbain, il est capital de prévoir le plus rapidement possible les zones à risque potentiel et mettre en œuvre des mesures de protection de la population (confinement, évacuation...).

En général, l'écoulement de l'air et la dispersion du polluant sont simulés en résolvant numériquement les équations de Navier-Stokes et l'équation de transport du polluant. Depuis le début des années 2000, les modèles de CFD (*Computational Fluid Dynamics*) ont été adaptés afin qu'ils tiennent compte des caractéristiques de l'environnement naturel ou bâti. Ces modèles permettent de reproduire avec réalisme les écoulements locaux et la répartition spatio-temporelle d'un polluant, y compris sur des sites au relief complexe et qui présentent des bâtiments. Ces modèles ont fait l'objet de campagnes de validation expérimentale qui montrent que les résultats numériques sont très proches de la réalité du terrain. Dans la suite du mémoire, les résultats de modèles physiques sont donc assimilés à la réalité de terrain. Par contre, les modèles de CFD nécessitent généralement beaucoup de temps de calcul et des ressources importantes (mémoire, processeurs...).

A titre d'illustration, on a simulé pour un nombre très important de conditions météorologiques et de localisations de la source, la concentration intégrée sur deux heures d'un polluant rejeté de façon accidentelle hypothétique dans l'hyper-centre urbain de Grenoble. Les résultats sont présentés sous forme de cartographies 2D à hauteur d'homme du champ de concentration intégrée. Ce sont ces résultats qui servent dans l'apprentissage et constituent la référence dans la mise en œuvre des algorithmes présentés. Autrement dit, les données d'apprentissage sont constituées par une cartographie ou morphologie 3D d'une zone spatiale d'apprentissage réelle et d'un ensemble de scénarios de différentes conditions météorologiques et de différentes positions d'une source de polluant dans cette zone. La zone d'apprentissage est, par exemple, une zone urbaine.

Avantageusement, la zone géographique choisie est suffisamment large pour intégrer une grande variété de bâtiments et obstacles urbains qui sont représentatifs d'une zone urbaine moyenne, de telle sorte que le modèle entrainé sur cette zone géographique particulière sera ensuite applicable à d'autres zones spatiales.

Dans la phase d'apprentissage, on détermine tout d'abord une solution simplifiée sans contraintes spatiales. Dans ce cas, on ne prend pas en compte les bâtiments, véhicules, etc. présents dans le milieu urbain.

$\tilde{U}$ est, ici, une solution analytique qui fournit la concentration du polluant selon la formule du panache gaussien et utilise comme paramètres la direction $\theta$ et vitesse v du vent au-dessus de la canopée urbaine. Dans sa formulation, ce modèle considère le sol plat et ignore tout bâtiment, ce qui permet une résolution analytique directe. Bien sûr, cette solution n'est qu'une approximation lointaine de la réalité du terrain dans un centre urbain d'une ville à la morphologie 3D des bâtiments possiblement complexe.

La solution gaussienne est analytiquement déterminée comme suit :

$$C(x, y, z = z_0, t) = \frac{Q}{2\pi\, \sigma_x \sigma_y} exp\left(-\frac{(x - vt)^2}{2{\sigma_x}^2}\right) exp\left(-\frac{y^2}{2{\sigma_y}^2}\right) \qquad (4)$$

Où :

- C représente la concentration dans l'air au point de coordonnées (x, y, z) à l'instant t
- Q représente la quantité rejetée
- v représente la vitesse du vent
- t représente le temps depuis le début du rejet
- $z_0$ représente la hauteur de la source du rejet
- x, y, z sont les coordonnées relatives du point considéré par rapport au point de rejet (l'axe des x correspond à la direction du vent $\theta$, l'axe des y est transverse à la direction du vent)
- $\sigma_x$ et $\sigma_y$ sont les écarts-type de la distribution gaussienne (qui peuvent être expérimentaux, ou collectés dans une table pour différentes conditions météorologiques disponibles au public)

Dans l'équation (4), la concentration est calculée à la même hauteur que celle du rejet ($z_0$), d'où l'absence de dépendance en z. Avec l'équation (4), nous disposons de la solution simplifiée. L'étape suivante est de représenter la matrice de contraintes spatiales.

La figure 7 représente schématiquement une illustration d'une zone urbaine comprenant un ensemble d'obstacles physiques (hyper-centre de Grenoble) à prendre en compte dans une matrice de contrainte selon le premier exemple de réalisation de l'invention. La matrice de contraintes spatiales est représentée par une coupe 2D de la carte des bâtiments. Ces derniers sont supposés de composition similaire (ils ont tous un effet sur l'écoulement) et sont considérés dans ce cas d'exemple comme étant imperméables au polluant. On définit donc une matrice binaire dont les éléments sont à 0 en présence d'un bâtiment et à 1 dans le cas contraire.

Ensuite, pour la fonction de masquage 141, on considère un seul filtre de convolution de taille 3 $\times$ 3, dont les

valeurs sont fixées à $K_1 = \begin{pmatrix} 0 & 0 & 0 \\ 0 & 1 & 0 \\ 0 & 0 & 0 \end{pmatrix}$. Comme l'effet des bâtiments sur le polluant (imperméabilité) est parfaitement modélisé par la matrice de contraintes spatiales, on choisit de fixer les valeurs du filtre (non-entraînable) de manière à ce que $C_C = M_C$. Ensuite, on multiplie les concentrations intégrées du panache gaussien $\tilde{U}$ par $C_C$. On obtient alors la solution intermédiaire à laquelle on va appliquer une fonction de correction.

Pour cela, on utilise un réseau de neurones de type encodeur/décodeur, composé d'une couche d'entrée, trois couches cachées et d'une couche de sortie :

- La couche d'entrée transforme la matrice $\tilde{U}_M$ en un vecteur de taille $100 \times 100$ ;
- Les trois couches cachées sont composées chacune de 2048 neurones, avec une fonction d'activation ReLU ;
- La couche de sortie (décodeur) est composée de $10^4$ neurones, pour reconstruire une matrice de mêmes dimensions que $\tilde{U}_M$ ($100 \times 100$).

Une fois que la fonction de correction est connue, on l'applique à la solution intermédiaire. Puis, on viendra appliquer de nouveau la fonction de masquage pour rétablir les contraintes spatiales. On obtient alors le modèle qui peut ensuite être utilisé, dans une phase d'exploitation, pour prévoir la concentration du polluant intégrée dans des zones urbaines quelconques (de Grenoble ou d'ailleurs) jusque-là jamais rencontrées durant la phase d'apprentissage.

La figure 8 illustre des cartes de concentrations (échelle logarithmique) du résultat final et des résultats intermédiaires du modèle d'apprentissage (en phase d'exploitation) sur la dispersion atmosphérique d'un polluant dans l'hyper-centre de Grenoble selon le premier exemple de réalisation de l'invention.

La solution du modèle gaussien (en haut à gauche de la figure 8) donne une idée de la dispersion en l'absence d'obstacles : sur un terrain plat, l'écoulement a une forme conique suivant la direction du vent. En appliquant un masquage binaire (en haut à droite de la figure 8), on remarque la limitation de l'écoulement aux zones fluides (rues) sur le support du panache gaussien. A ce stade, l'interaction avec les bâtiments n'est pas encore prise en compte et on remarque des discontinuités brusques et artificielles des niveaux de concentration. La fonction de correction permet ensuite de lisser la répartition du polluant et de répercuter l'effet des intersections de rues autour de la source (en bas à gauche de la figure 8). Finalement, les contraintes spatiales sont rétablies grâce à la deuxième fonction de masquage (en bas à droite de la figure 8).

La figure 9 représente la répartition du polluant simulée par un modèle CFD de référence et assimilée à la réalité du terrain.

Le tableau ci-dessous compare les résultats intermédiaires et la prévision finale avec la réalité terrain qui est, rappelons-le, la solution du modèle CFD de référence (représentée sur la figure 9). Deux métriques sont considérées : l'erreur quadratique moyenne qui mesure l'erreur de prévision et le SSIM (abréviation de *Structural Similarity*) qui est généralement utilisé pour quantifier la similarité entre images. On remarque que la prévision finale est précise, avec un SSIM à 80% et une faible erreur quadratique moyenne. De plus, on note l'augmentation du MSE (*Mean Squared Error*) après l'étape de correction et, par conséquent, l'importance des deux masquages dans le processus global.

| Métrique | Solution gaussienne | Masquage | Correction | Prévision finale |
|---|---|---|---|---|
| ***Mean Squared Error* (MSE)** | 2,1 | 1,7 | 2,3 | 0,6 |
| SSIM | 0,6 | 0,67 | 0,52 | 0,79 |

On peut également noter que la prévision générée est quasi-instantanée (quelques millisecondes sur un PC portable ordinaire : 16 Go RAM, CPU Intel i5). La méthode de l'invention permet ainsi de déterminer avec précision, et de manière extrêmement rapide, un niveau d'une grandeur physique (ici, une concentration d'une espèce chimique) dans une pluralité d'environnements non figés, avec des contraintes spatiales jusqu'alors non-rencontrées lors de la phase d'apprentissage.

La figure 10 représente un organigramme détaillant les étapes de mise en œuvre d'une procédure d'apprentissage pour la résolution d'EPD de propagation d'onde acoustique selon un deuxième exemple de réalisation de l'invention. Dans cet exemple, le phénomène étudié est la propagation d'ondes acoustiques en présence d'obstacles et la grandeur physique dont on souhaite suivre l'évolution est le niveau de pression acoustique dans l'environnement physique choisi.

La pollution sonore est devenue un problème majeur pouvant avoir des répercussions graves sur la santé ainsi que la qualité de vie humaine. La planification de l'isolation phonique pour différentes sources de bruits (par exemple voies routières, chantiers, usines...) est donc indispensable.

La propagation d'ondes sonores dans un milieu est modélisée par une EDP dérivée de la mécanique des fluides, représentant l'évolution de la pression acoustique en fonction des coordonnées de l'espace et du temps. En présence de contraintes spatiales bidimensionnels, l'EDP est résolue par des méthodes numériques. En particulier, T. Komatsuzaki *et al.* (voir référence [5]) proposent une modélisation par automate cellulaire, s'appuyant sur une méthode de résolution à différences finies sur un maillage rectangulaire avec linéarisation locale de l'EDP. La nature réfléchissante des contraintes spatiales est représentée dans les règles de transition de l'automate. Les auteurs montrent que leur modélisation de propagation acoustique en présence d'obstacles est très réaliste à condition d'avoir un maillage fin, ce qui conduit à des temps de calculs extrêmement longs et nécessite des ressources informatiques importantes. Les résultats de ce modèle seront considérés par la suite comme la réalité du terrain.

Pour cet exemple, la propagation d'ondes acoustiques a été simulée pour différentes configurations de contraintes spatiales générées aléatoirement (nombres d'obstacles, leurs formes géométriques et leurs positions). La source sonore consiste en une perturbation sinusoïdale localisée au centre du milieu de propagation. Les résultats sont présentés sous forme de cartographies 2D du niveau de pression acoustique, qui représentent l'intensité du bruit en régime permanent à chaque point de l'espace. Ces résultats sont utilisés pour alimenter et valider la procédure d'apprentissage représentée dans la figure 10.

Autrement dit, dans ce deuxième exemple d'application de l'invention, les données d'apprentissage peuvent être constituées par plusieurs cartographies ou morphologies 3D de différentes zones spatiales réelles ou simulées et d'un ensemble de scénarios de différentes positions des sources sonores dans les zones d'apprentissage spatiales ainsi que différentes caractéristiques des sources sonores (type de la source,notamment type du dispositif émetteur de la source).

La solution $\tilde{U}$ est dérivée du modèle d'automate cellulaire présenté auparavant. Il s'agit de simuler la propagation d'une onde acoustique dans un milieu libre, c'est-à-dire en l'absence totale d'obstacles.

La figure 11 représente schématiquement une illustration d'obstacles physiques à prendre en compte dans une matrice de contrainte selon le deuxième exemple de réalisation de l'invention. La matrice de contrainte représente dans une coupe 2D les obstacles physiques dans le milieu de propagation. Ces derniers sont supposés être imperméables et réfléchissent l'onde acoustique dans sa totalité. On définit donc une matrice binaire dont les éléments sont à 0 en présence d'obstacle et à 1 dans le cas contraire.

Pour la fonction de masquage, on considère un seul filtre de convolution de taille 3 × 3, dont les valeurs sont fixées à $K_1 = \begin{pmatrix} 0 & 0 & 0 \\ 0 & 1 & 0 \\ 0 & 0 & 0 \end{pmatrix}$. Les obstacles sont des milieux où l'onde acoustique ne se propage pas, ce qui est parfaitement modélisé par la matrice de contraintes spatiales. On choisit de fixer les valeurs du filtre (non-entraînable) de manière à ce que $C_C = M_C$. Ensuite, on multiplie les niveaux de pression acoustique $\tilde{U}$ par $C_C$ et on obtient une solution intermédiaire $\tilde{U}_M$.

La figure 12 représente un schéma de principe général de la fonction de correction pour la propagation acoustique modélisée par un réseau de convolutions multi-échelles selon un mode de réalisation de l'invention.

Dans cet exemple, un réseau de convolution multi-échelles innovant est utilisé. La matrice en entrée $\tilde{U}_M$ est distribuée à l'identique à plusieurs branches de convolution. Chaque branche $i \in \{0,1, ...,9\}$ est composée de 10 couches, dont chacune consiste en une convolution avec 100 kernels de dimensions 3 + 2i × 3 + 2i suivie d'une activation *Exponential Linear Unit* (ELU). Les 100 cartes de caractéristiques produites à chaque couche, de même dimension que $\tilde{U}_M$, sont par la suite centrées et réduites (*Batch Normalization,* d'abréviation BN) avant d'être transmises à la couche suivante. Arrivées à la dernière couche de la branche, les cartes de caractéristiques sont fusionnées par un filtre convolutif de taille 1 × 1.

A ce stade, chaque branche produit une matrice de même dimension que $\tilde{U}_M$. Ces matrices sont ensuite fusionnées une dernière fois pour produire la matrice de sortie.

Il faut noter qu'il s'agit ici d'un exemple non-limitatif de modélisation de la fonction de correction par un réseau de convolutions multi-échelles. L'Homme du métier peut, sur la base de ses connaissances, choisir d'autres types de réseaux de neurones adaptés.

Pour finir, la fonction de masquage est appliquée à la matrice de sortie de l'étape précédente pour bien prendre en compte la réalité spatio-temporelle. Comme mentionné précédemment, plusieurs itérations masquage et correction et masquage peuvent avoir lieu.

La fonction de correction peut être déterminée lors d'une phase d'apprentissage comprenant une étape d'exécution de plusieurs itérations d'un algorithme d'apprentissage automatique, recevant en entrée la solution intermédiaire, l'algorithme d'apprentissage automatique étant configuré pour déterminer la fonction de correction. Les itérations de l'algorithme d'apprentissage automatique sont arrêtées après l'exécution d'un nombre prédéterminé d'itérations ou quand l'erreur entre le niveau de la grandeur physique dans la zone prédéfinie et un niveau de référence de la grandeur physique dans la zone prédéfinie est inférieure à un seuil de convergence prédéterminé.

Quand les paramètres de la fonction de correction sont appris et que le modèle pour la grandeur physique est obtenu (ici, modèle pour le niveau de pression acoustique), on utilise le modèle résultant, dans une phase d'exploitation, pour prévoir le niveau de pression acoustique dans un milieu dont la forme et l'agencement des obstacles sont inédits (non rencontrés durant la phase d'apprentissage).

La figure 13 illustre des cartes de niveaux de pression acoustique (en décibels) du résultat final et des résultats intermédiaires du modèle d'apprentissage (en phase d'exploitation) sur la propagation acoustique dans un milieu avec obstacles selon le deuxième exemple de réalisation de l'invention. La solution du modèle numérique (en haut à gauche de la figure 13) est valable dans un milieu libre (sans obstacles): la propagation est isotrope et on remarque l'effet d'interférences constructrices et destructrices, symétriques par rapport à la source au centre de la carte. L'application d'un masquage binaire (en haut à droite de la figure 13) force l'absence de propagation du son au sein des obstacles. Ensuite (en bas à gauche de la figure 13), la fonction de correction permet de reproduire le comportement physique issu de l'interaction entre les obstacles et l'onde acoustique (réflexion et interférence). Finalement, les contraintes spatiales aux interfaces des obstacles sont rétablies grâce à la deuxième fonction de masquage (en bas à droite de la figure 13).

La figure 14 représente les niveaux de pression acoustique, simulée par le modèle d'automate cellulaire décrit dans la référence [5] et assimilée à la réalité du terrain.

Le tableau ci-dessous compare les résultats intermédiaires et la prévision finale avec la réalité terrain qui est, rappelons-le, la solution du modèle d'automate cellulaire (figure 14). Comme pour l'exemple de dispersion atmosphérique du polluant, on considère deux métriques qui sont le MSE et le SSMI. Encore une fois, on remarque une amélioration importante du SSIM et une forte baisse du MSE grâce aux opérations de masquage et de corrections consécutives.

| Métrique | Solution numérique | Masquage | Correction | Prévision finale |
|---|---|---|---|---|
| ***Mean Squared Error* (MSE)** | 1104 | 53 | 114 | 22 |
| SSIM | 0,1 | 0,38 | 0,52 | 0,6 |

La prévision générée par le modèle appris nécessite en moyenne 1 minute de calcul (sans parallélisation, sur un PC portable ordinaire : 16 Go RAM, CPU Intel i5).

La méthode selon l'invention peut comprendre une étape de restitution des résultats obtenus lors de la phase d'exploitation via une interface graphique sous la forme d'une cartographie 2D de la zone spatiale visée dans laquelle est représentée le niveau estimé de la grandeur physique (polluant chimique ou sonore dans le cas des deux exemples d'application précités).

La visualisation graphique des résultats peut intégrer un seuil d'alerte permettant à l'utilisateur de visualiser les zones dans lesquelles le niveau de la grandeur physique dépasse ce seuil d'alerte. Par exemple, cela peut être réalisé en associant des niveaux de couleur différents pour différents niveaux de la grandeur physique.

La méthode de l'invention peut comprendre une étape de détermination de mesures de protection applicables si le niveau de la grandeur physique atteint le seuil d'alerte préalablement défini. Dans le cas d'un rejet accidentel d'un polluant chimique, la détermination de protection peut être une action correctrice (filtration ou captage du polluant) ou une action protectrice (confinement ou évacuation de la population dans un certain périmètre). Dans le cas de propagation d'ondes acoustiques, la détermination de protection peut être une action protectrice par le biais d'installation d'une isolation phonique adaptée.

Ainsi un utilisateur peut mettre en œuvre des mesures de protection ou de correction à partir de la visualisation graphique des résultats et de l'implémentation du seuil d'alerte dans l'interface graphique.

Les mesures de protection ou de correction peuvent être préventives, en simulant des sources de pollution hypothétiques ou réactives en prenant en compte des sources de pollution réelles.

La figure 15 représente un schéma de principe d'une variante de la procédure d'apprentissage pour la résolution d'EDP soumise à des contraintes spatiales selon un autre mode de réalisation de l'invention. Dans cette variante, les sorties des sous-couches intermédiaires de correction/masquage peuvent être utilisées par les fonctions de correction plus éloignées dans l'architecture. Cela permet d'exploiter l'historique des transformations apportées quand cela est nécessaire pour affiner l'apprentissage.

L'invention est mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro-logiciel, un micro-code ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués (*"Cloud computing*"), éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. Une unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

Le programme d'ordinateur peut comprendre une interface graphique pour restituer les résultats de la méthode selon l'invention à un utilisateur sous la forme d'une cartographique d'une zone dans laquelle l'utilisateur souhaite évaluer le niveau de la grandeur physique visée.

L'invention peut être couplée à un système d'alerte permettant de déclencher une alerte lorsque le niveau de la grandeur physique dépasse un seuil prédéfini dans certaines zones spatiales.

Le principe de l'invention décrit à la figure 2 fonctionne donc selon deux phases successives : une première phase d'apprentissage lors de laquelle un modèle 13 pour une grandeur physique est déterminé au moyen d'un apprentissage automatique recevant en entrée un premier ensemble d'obstacles physiques 11 et un premier ensemble de conditions initiales 12, et une seconde phase opérationnelle, lors de laquelle le modèle 13 précédemment déterminé est utilisé pour déterminer un niveau de la grandeur physique pour un deuxième ensemble d'obstacles physiques (pas encore rencontré par le modèle lors de la phase d'apprentissage) et éventuellement d'autres conditions initiales.

Il apparaîtra plus généralement à l'Homme du métier que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'Homme du métier se basant sur ses connaissances générales.

Références

[1] Raissi, M., "Deep hidden physics models: Deep learning of nonlinear partial differential équations", The Journal of Machine Learning Research, 932-955, 2018.

[2] Wang, R., "Comparison of machine learning models for hazardous gas dispersion prédiction in field cases" International journal of environmental research and public health, 2018.

[3] Yu, R., "Long-term forecasting using tensor-train rnns", Arxiv, 2017.

[4] Z. Long, B. D., « Learning PDEs from data with a numeric symbolic hybrid deep network. Journal of Computational Physics », PDE-Net 2.0, 2019.

[5] Komatsuzaki, Toshihiko, Yoshio Iwata, and Shin Morishita, « Modelling of incident sound wave propagation around sound barriers using cellular automata », In International Conférence on Cellular Automata, 385-394. Springer, 2012.


**Revendications**

1. Méthode, mise en œuvre par ordinateur, de détermination d'un niveau d'une grandeur physique à évolution spatio-temporelle en présence d'obstacles physiques dans une zone spatiale choisie, l'évolution de ladite grandeur physique étant régie par un système d'équations aux dérivées partielles, la méthode comprenant les étapes suivantes :

   - Dans une phase d'apprentissage (100), détermination (110), au moyen d'un apprentissage automatique recevant en entrée un premier ensemble d'obstacles physiques (11) appartenant à une première zone spatiale d'apprentissage et un premier ensemble de conditions initiales (12), d'un modèle (13) pour ladite grandeur physique, et, optionnellement, d'un premier niveau (14) de la grandeur physique dans la zone spatiale d'apprentissage ;
- Dans une phase d'exploitation (200),
- détermination (210) d'un deuxième niveau (24) de la grandeur physique dans une seconde zone spatiale choisie, à partir du modèle (13) pour ladite grandeur physique recevant en entrée un deuxième ensemble d'obstacles physiques (21), distinct du premier ensemble d'obstacles physiques (11), et un deuxième ensemble de conditions initiales (22),

i. Affichage du deuxième niveau de la grandeur physique déterminé dans la zone spatialechoisie au moyen d'une interface graphique,
ii. détermination de mesures de protection applicables si le deuxième niveau de la grandeur physique atteint un seuil d'alerte préalablement défini.

**2.** Méthode de détermination d'un niveau d'une grandeur physique selon la revendication 1, dans laquelle l'étape (110) de détermination du modèle (13) pour ladite grandeur physique comprend les étapes de :

- Détermination (120) d'une solution simplifiée ($\tilde{U}$) du système d'équations aux dérivées partielles en absence d'obstacles physiques ;
- Représentation (130) du premier ensemble d'obstacles physiques (11) dans la zone spatiale d'apprentissage sous forme d'une première matrice de contraintes spatiales (Mc1) ;
- Application (140) à la solution simplifiée ($\tilde{U}$) d'une fonction de masquage (141) paramétrée par la première matrice de contraintes spatiales (Mc1) pour obtenir une première solution intermédiaire ( $\tilde{U}_M$) du système d'équations aux dérivées partielles en présence du premier ensemble d'obstacles physiques (11) ;
- Application (150) à la première solution intermédiaire ( $\tilde{U}_M$) d'une fonction de correction (151) déterminée par un réseau de neurones, pour obtenir le modèle pour ladite grandeur physique et une première solution corrigée ( $\tilde{U}_C$) de la grandeur physique dans la zone spatiale d'apprentissage ;
- Application (140) à la première solution corrigée ( $\tilde{U}_C$) de la fonction de masquage (141) paramétrée par la première matrice de contraintes spatiales (Mc1) pour obtenir le premier niveau (14) de la grandeur physique du système d'équations aux dérivées partielles dans la zone spatiale d'apprentissage en présence du premier ensemble d'obstacles physiques (11).

**3.** Méthode de détermination d'un niveau d'une grandeur physique selon la revendication 2, dans laquelle l'étape (200) de détermination du deuxième niveau (24) de la grandeur physique dans une zone spatiale choisie comprend les étapes suivantes :

- Représentation (230) du deuxième ensemble d'obstacles physiques (21) dans la zone spatiale choisie sous forme d'une deuxième matrice de contraintes spatiales (Mc2) ;
- Application (240) au modèle (13) d'une fonction de masquage (242) paramétrée par la deuxième matrice de contraintes spatiales (Mc2) pour obtenir une deuxième solution intermédiaire ( $\tilde{U}_{M2}$) du système d'équations aux dérivées partielles en présence du deuxième ensemble d'obstacles physiques (21) ;
- Application (250) à la deuxième solution intermédiaire ( $\tilde{U}_{M2}$) de la fonction de correction (151) du modèle, pour obtenir une deuxième solution corrigée ( $\tilde{U}_{C2}$) de la grandeur physique dans la zone spatiale choisie pour le deuxième ensemble d'obstacles physiques (21);
- Application (240) à la deuxième solution corrigée ( $\tilde{U}_{C2}$ ) de la fonction de masquage (242) paramétrée par la deuxième matrice de contraintes spatiales (Mc2) pour obtenir le deuxième niveau (24) de la grandeur physique du système d'équations aux dérivées partielles dans la zone spatiale choisie en présence du deuxième ensemble d'obstacles physiques (21).

**4.** Méthode de détermination d'un niveau d'une grandeur physique selon l'une quelconque des revendications 2 ou 3, dans laquelle la fonction de masquage (142, 242) est un groupe d'opérations de convolution avec fonction d'activation non-linéaires.

**5.** Méthode de détermination d'un niveau d'une grandeur physique selon l'une quelconque des revendications 2 à 4, dans laquelle la fonction de correction (151) est déterminée lors d'une phase d'apprentissage comprenant une étape d'exécution de plusieurs itérations d'un algorithme d'apprentissage automatique, recevant en entrée la solution intermédiaire, l'algorithme d'apprentissage automatique étant configuré pour déterminer la fonction de correction.

6. Méthode de détermination d'un niveau d'une grandeur physique selon la revendication 5, dans laquelle les itérations de l'algorithme d'apprentissage automatique sont arrêtées après l'exécution d'un nombre prédéterminé d'itérations ou quand l'erreur entre le niveau de la grandeur physique dans la zone spatiale d'apprentissage et un niveau de référence de la grandeur physique dans la zone spatiale d'apprentissage est inférieure à un seuil de convergence prédéterminé.

7. Méthode de détermination d'un niveau d'une grandeur physique selon l'une quelconque des revendications 1 à 6, dans laquelle la grandeur physique est un polluant, préférentiellement chimique ou sonore.

8. Méthode de détermination d'un niveau d'une grandeur physique selon l'une quelconque des revendications précédentes dans laquelle l'apprentissage automatique du modèle réalisé lors de la phase d'apprentissage (100) est alimenté par des données d'apprentissage comprenant une cartographie ou morphologie de la zone spatiale d'apprentissage réelle, comprenant ledit premier ensemble d'obstacles physiques (11).

9. Méthode de détermination d'un niveau d'une grandeur physique selon la revendication 8 dans laquelle les données d'apprentissage comprennent en outre différents ensembles de conditions initiales (12) appliquées à la zone spatiale d'apprentissage comprenant au moins différents ensembles de positions des sources d'émission de ladite grandeur physique dans la zone spatiale d'apprentissage.

10. Méthode de détermination d'un niveau d'une grandeur physique selon la revendication 9 dans laquelle les différents ensembles de conditions initiales (12) comprennent différents modèles de conditions météorologiques impactant la zone spatiale d'apprentissage

11. Programme d'ordinateur comportant des instructions pour l'exécution de la méthode selon l'une quelconque des revendications 1 à 10, lorsque le programme est exécuté par un processeur.

12. Support d'enregistrement lisible par un processeur sur lequel est enregistré un programme comportant des instructions pour l'exécution de la méthode selon l'une quelconque des revendications 1 à 10, lorsque le programme est exécuté par un processeur.

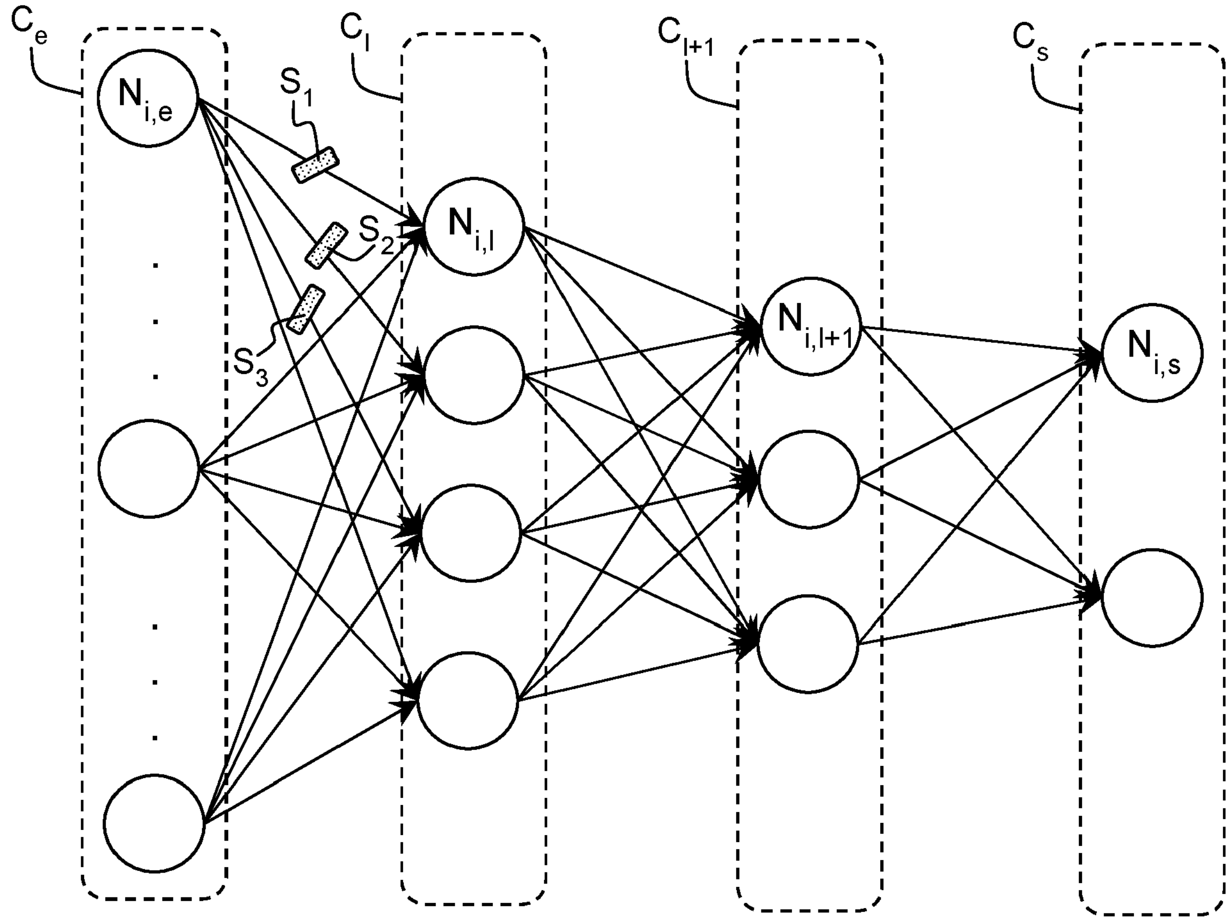


FIG.1

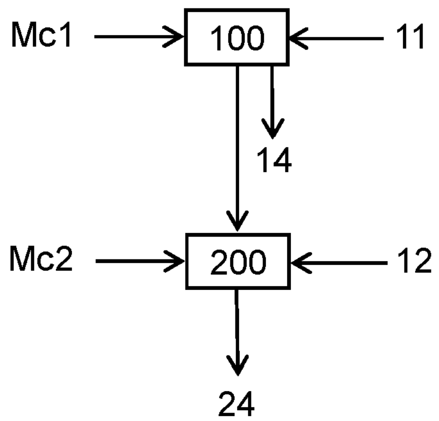


FIG.2

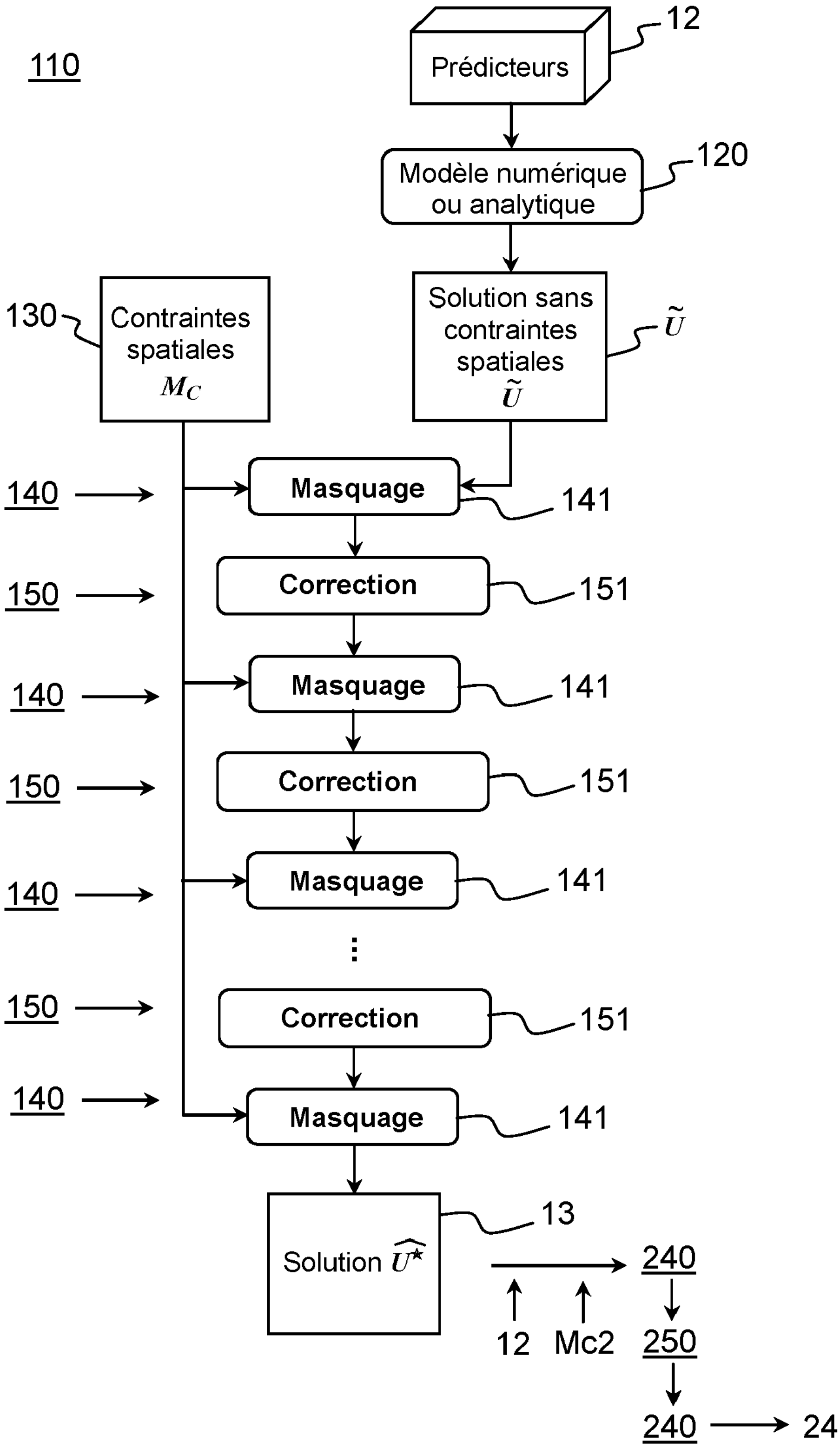
110
Prédicteurs
12
Modèle numérique ou analytique
120
Contraintes spatiales $M_C$
130
Solution sans contraintes spatiales $\tilde{U}$
$\tilde{U}$
140
Masquage
141
150
Correction
151
140
Masquage
141
150
Correction
151
140
Masquage
141
150
Correction
151
140
Masquage
141
Solution $\widehat{U^{\star}}$
13
240
12
Mc2
250
240
24

FIG.3

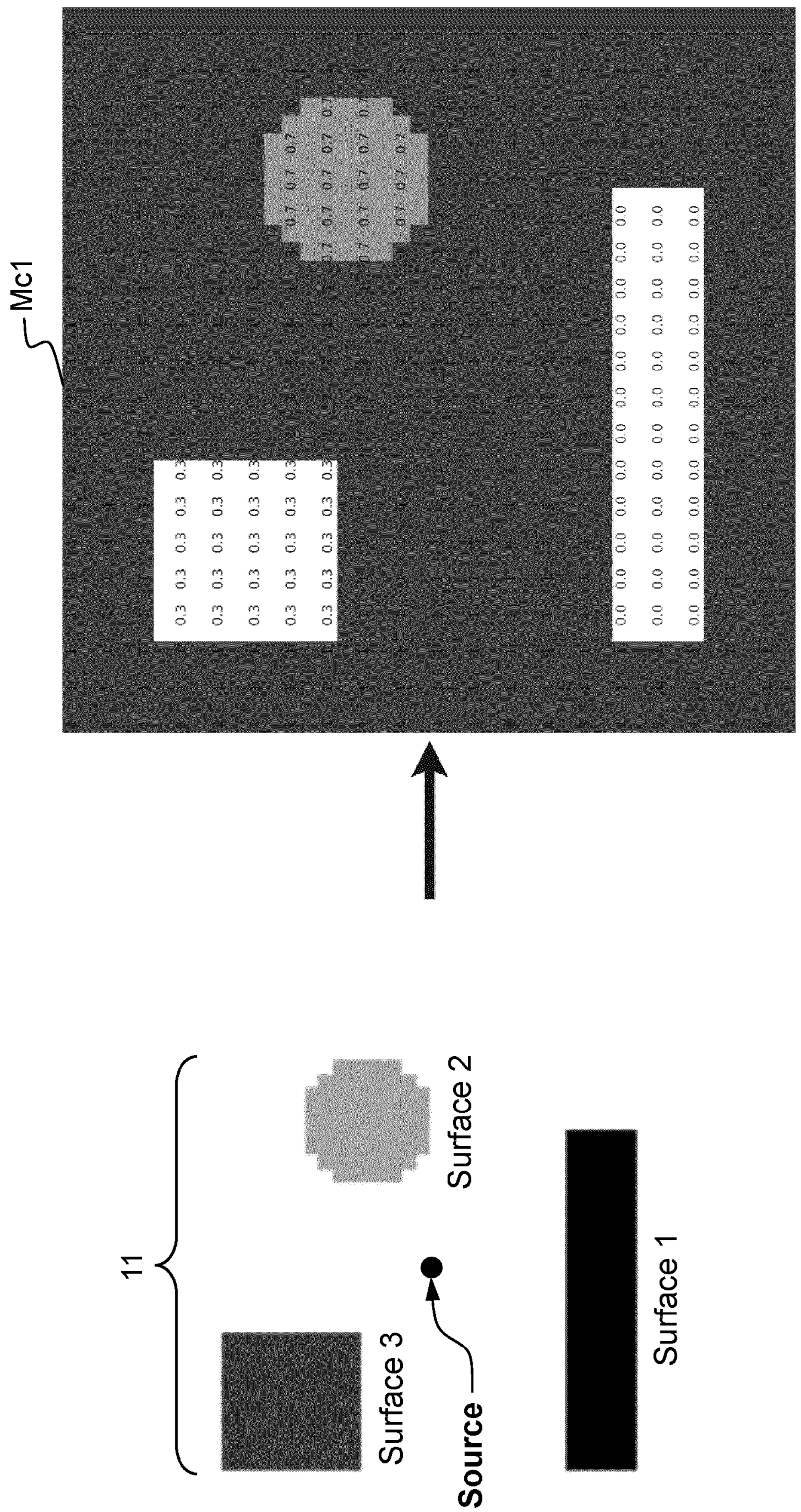


FIG.4

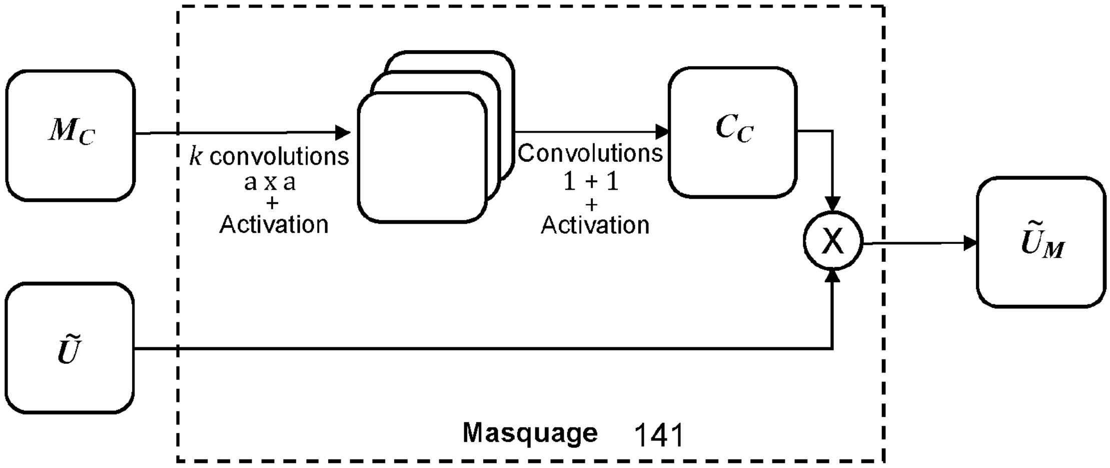
$M_C$
k convolutions
a x a
+
Activation
Convolutions
1 + 1
+
Activation
$C_C$
X
$\tilde{U}_M$
$\tilde{U}$
Masquage 141

FIG.5

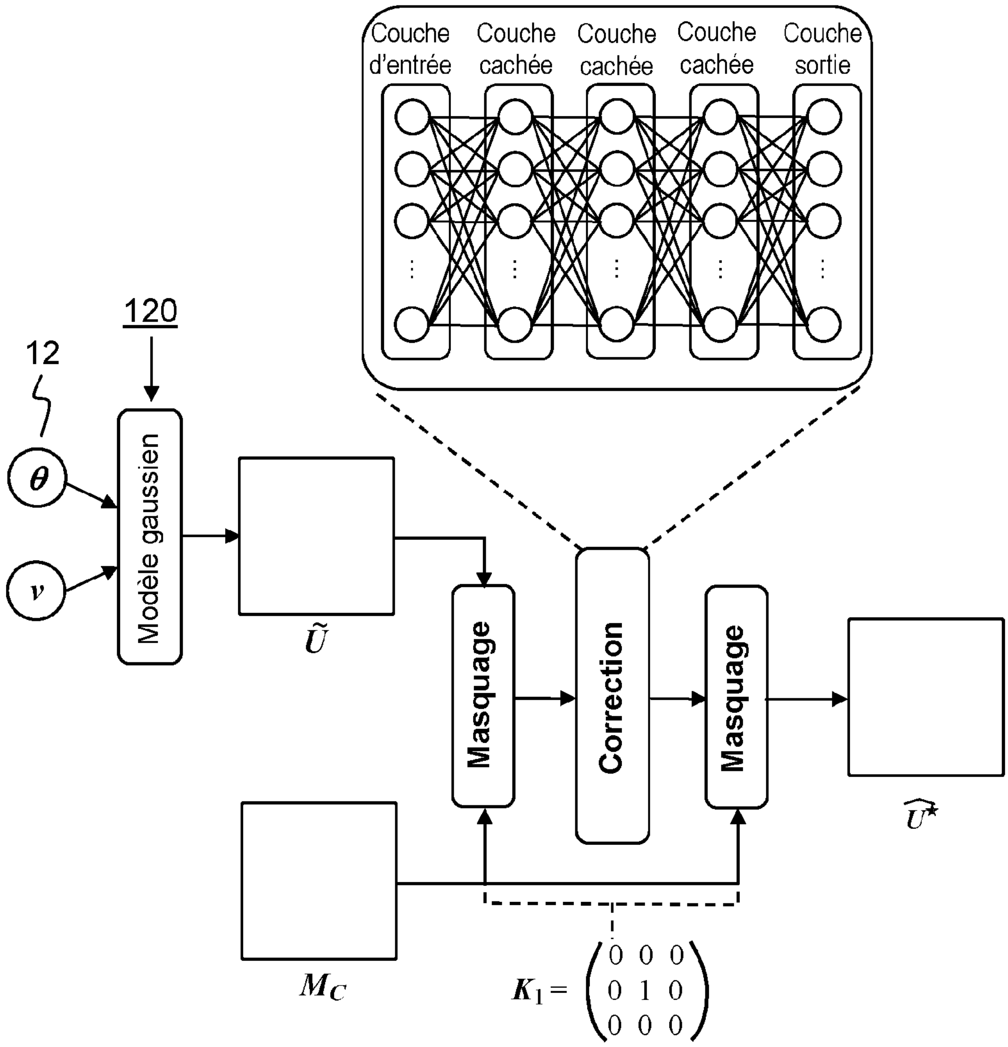
Couche d'entrée
Couche cachée
Couche cachée
Couche cachée
Couche sortie
120
12
θ
ν
Modèle gaussien
$\tilde{U}$
Masquage
Correction
Masquage
$\widehat{U^\star}$
$M_C$
$K_1 = \begin{pmatrix} 0 & 0 & 0 \\ 0 & 1 & 0 \\ 0 & 0 & 0 \end{pmatrix}$

FIG.6

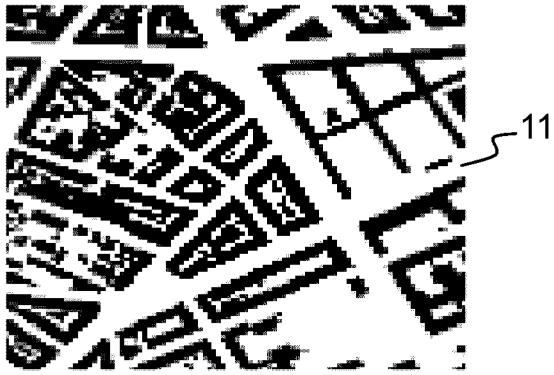
11

FIG.7

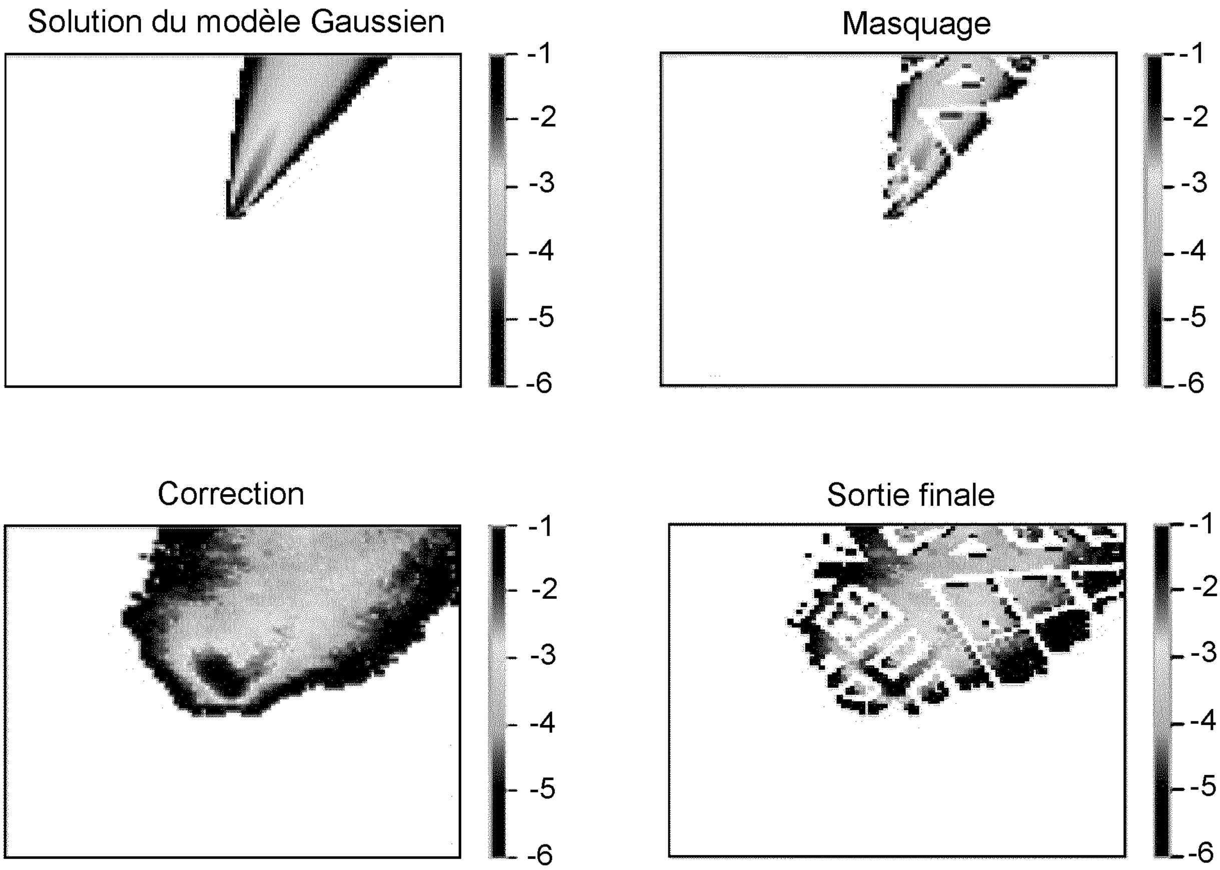
Solution du modèle Gaussien
-1
-2
-3
-4
-5
-6
Masquage
-1
-2
-3
-4
-5
-6
Correction
-1
-2
-3
-4
-5
-6
Sortie finale
-1
-2
-3
-4
-5
-6

FIG.8

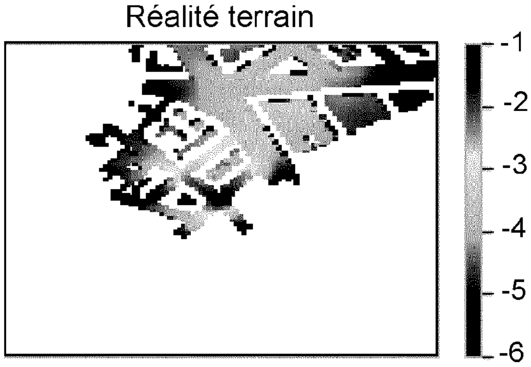


FIG.9

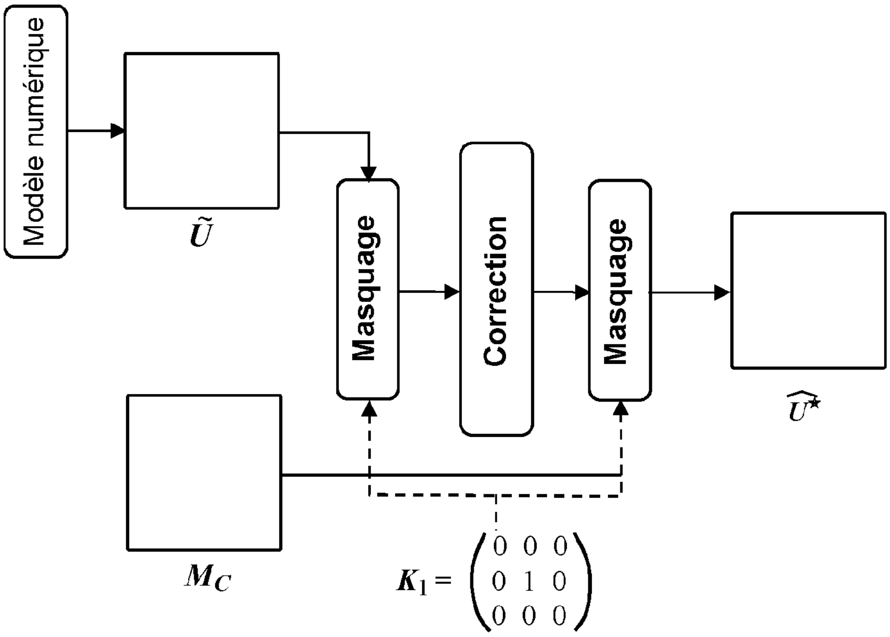


FIG.10

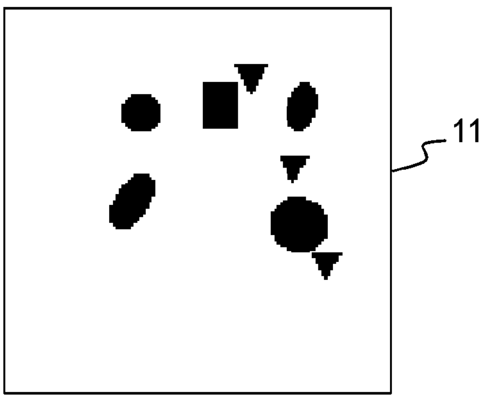


FIG.11

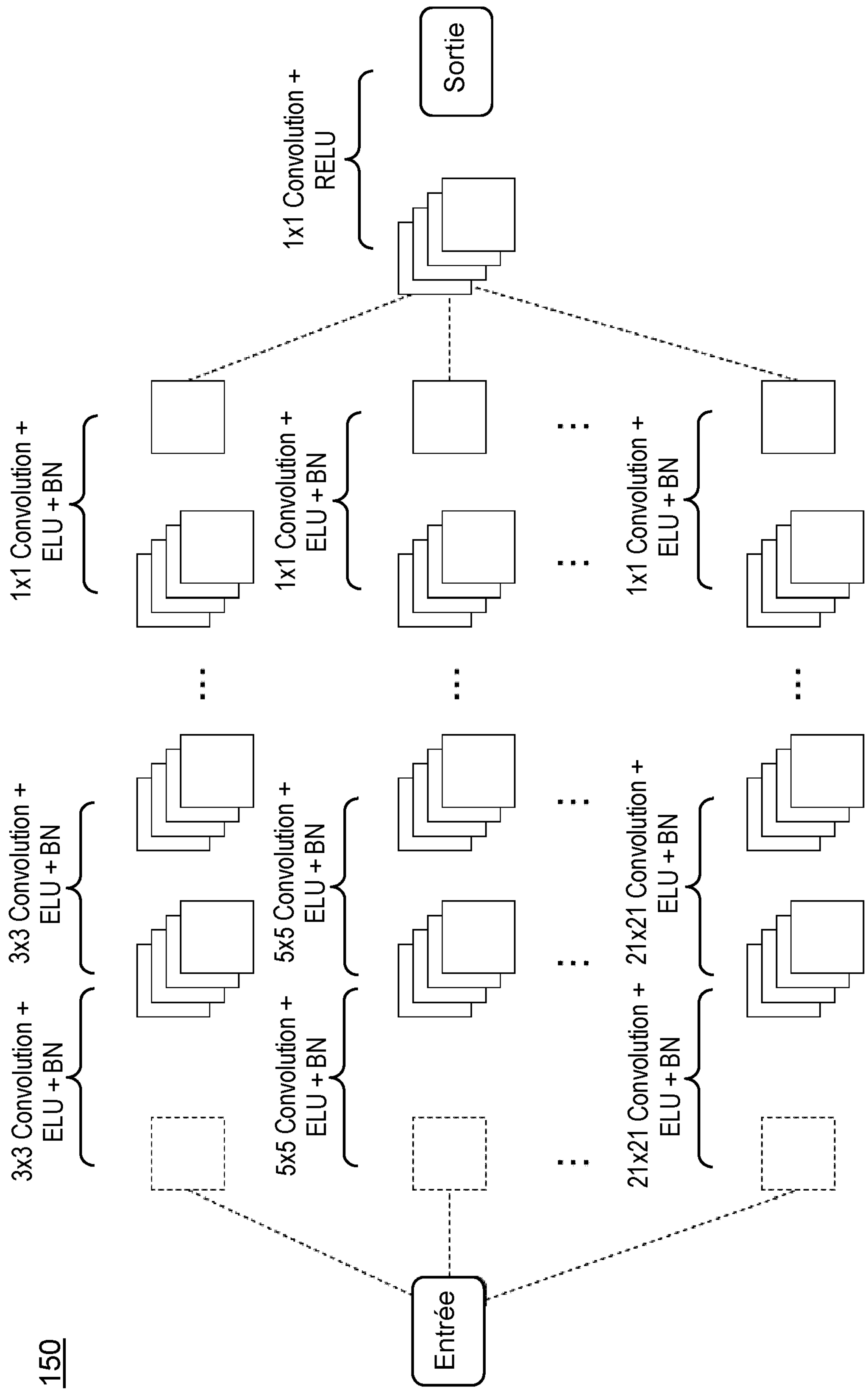
150
Entrée
3x3 Convolution + ELU +BN
3x3 Convolution + ELU +BN
5x5 Convolution + ELU +BN
5x5 Convolution + ELU +BN
21x21 Convolution + ELU +BN
21x21 Convolution + ELU +BN
1x1 Convolution + ELU +BN
1x1 Convolution + ELU +BN
1x1 Convolution + ELU +BN
1x1 Convolution + RELU
Sortie

FIG.12

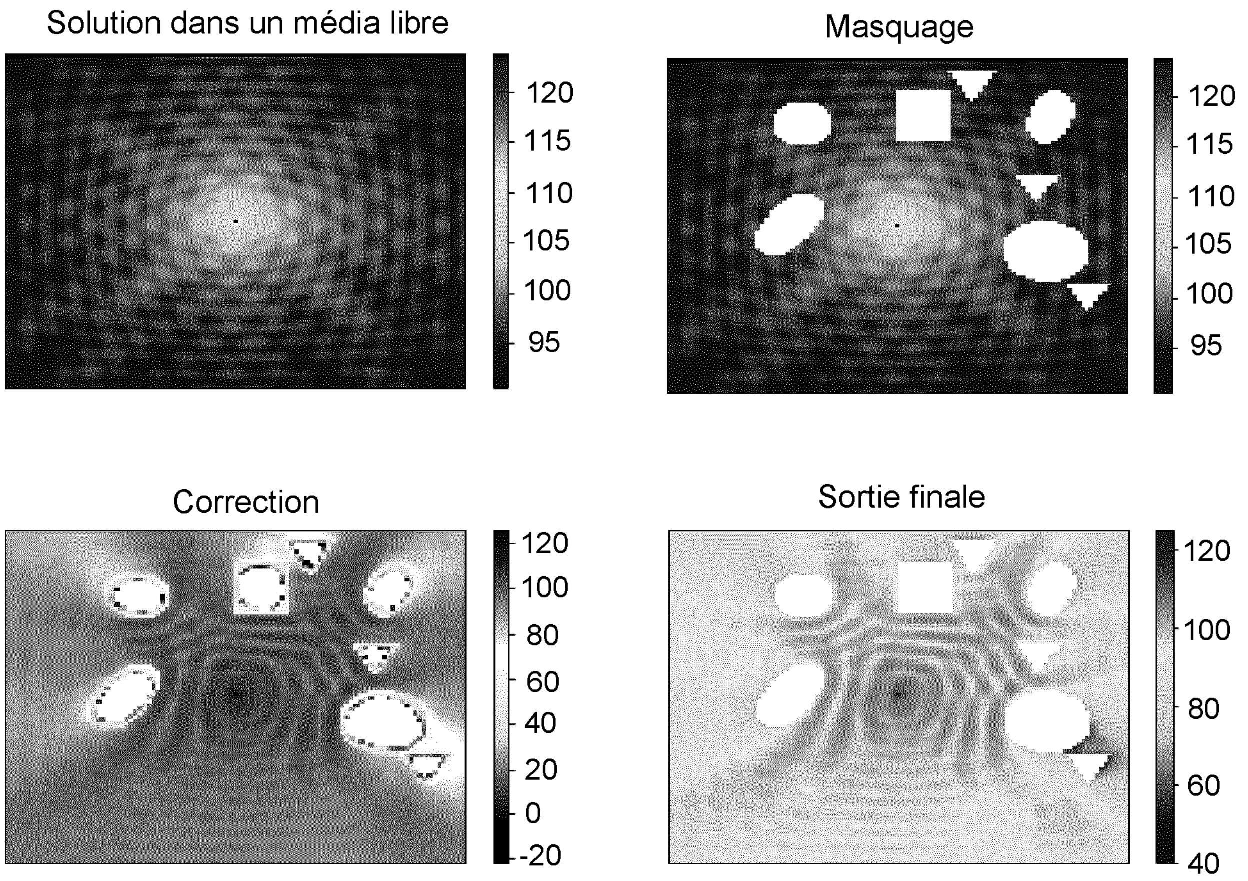
Solution dans un média libre
120
115
110
105
100
95
Masquage
120
115
110
105
100
95
Correction
120
100
80
60
40
20
0
-20
Sortie finale
120
100
80
60
40

FIG.13

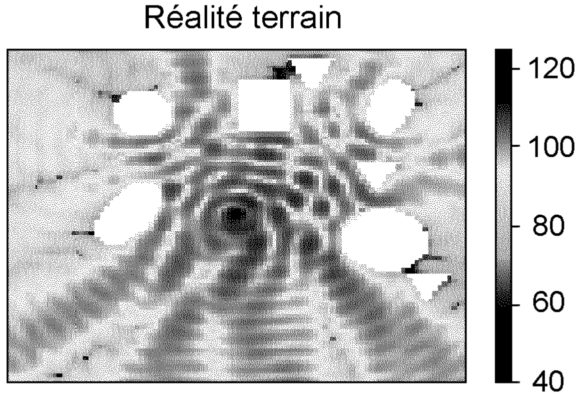
Réalité terrain
120
100
80
60
40

FIG.14

110

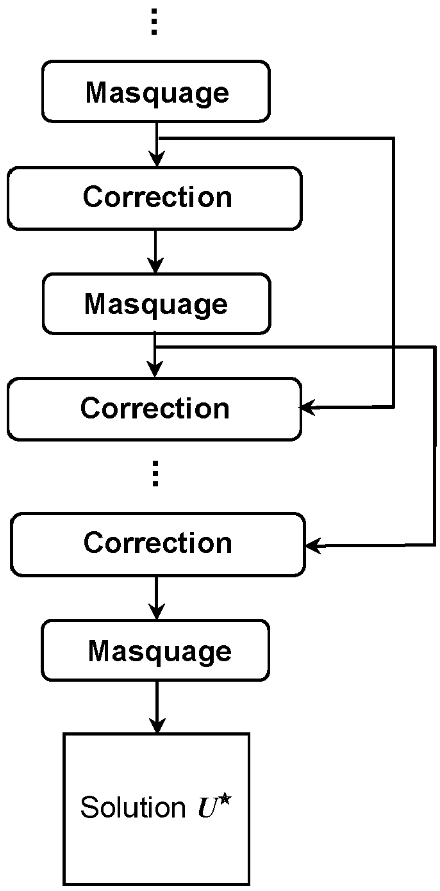
Masquage
Correction
Masquage
Correction
Correction
Masquage
Solution $U^\star$

FIG.15

Europäisches Patentamt
European Patent Office
Office européen des brevets

# RAPPORT DE RECHERCHE EUROPEENNE

Numéro de la demande
EP 22 16 6819

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | Eichinger Matthias ET AL: "Technical Report Series Center for Data and Simulation Science Stationary flow predictions using convolutional neural networks Stationary flow predictions using convolutional neural networks", , 16 décembre 2019 (2019-12-16), pages 1-9, XP055869117, Extrait de l'Internet: URL:https://kups.ub.uni-koeln.de/10440/1/CDS_TR-2019-20.pdf [extrait le 2021-12-03] * le document en entier * ----- | 1-12 | INV. G06F30/27 G06F30/28 G06N3/08 G06F17/13 |
| | | | DOMAINES TECHNIQUES RECHERCHES (IPC) |
| | | | G06F G06N |

Le présent rapport a été établi pour toutes les revendications

1

| Lieu de la recherche | Date d'achèvement de la recherche | Examinateur |
|---|---|---|
| Munich | 16 août 2022 | Leuridan, Koen |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2017035781 W

### Littérature non-brevet citée dans la description


- **RAISSI, M.** Deep hidden physics models: Deep learning of nonlinear partial differential équations. *The Journal of Machine Learning Research,* 2018, 932-955
- **WANG, R.** Comparison of machine learning models for hazardous gas dispersion prédiction in field cases. *International journal of environmental research and public health,* 2018
- **YU, R.** Long-term forecasting using tensor-train rnns. *Arxiv,* 2017
- **Z. LONG, B. D.** Learning PDEs from data with a numeric symbolic hybrid deep network. *Journal of Computational Physics,* 2019
- Modelling of incident sound wave propagation around sound barriers using cellular automata. **KOMATSUZAKI, TOSHIHIKO ; YOSHIO IWATA ; SHIN MORISHITA.** International Conférence on Cellular Automata. Springer, 2012, 385-394